# EUROPÄISCHE PATENTSCHRIFT

(11) **EP 1 866 655 B1**
(45) Veröffentlichungstag und Bekanntmachung des Hinweises auf die Patenterteilung: **02.06.2010**
(21) Anmeldenummer: 06723741.2
(22) Anmeldetag: 25.03.2006
(51) Int. Cl.: G01R 19/25

(54) **EINRICHTUNG ZUR ENERGIEVERSORGUNG VON MESSSENSOREN UND ÜBERTRAGUNG EINES SYNCHRONEN TAKTSIGNALS AN DIESE**
DEVICE FOR SUPPLYING POWER TO MEASURING SENSORS AND TRANSMITTING A SYNCHRONOUS CLOCK SIGNAL THERETO
EQUIPEMENT D'ALIMENTATION EN ENERGIE DE CAPTEURS DE MESURE ET TRANSMISSION D'UN SIGNAL D'HORLOGE SYNCHRONE A CES DERNIERS

(30) Priorität: 07.04.2005 DE 102005015942
(43) Veröffentlichungstag der Anmeldung: 19.12.2007
(73) Patentinhaber: ABB AG, 68309 Mannheim (DE)
(72) Erfinder: MAST, Jochen, 69126 Heidelberg (DE); WEIERS, Stefan, 69126 Heidelberg (DE); MÜLLER, Klaus-Georg, 69259 Wilhelmsfeld (DE)
(74) Vertreter: Miller, Toivo
(86) Internationale Anmeldenummer: PCT/EP2006/002763
(87) Internationale Veröffentlichungsnummer: WO 2006/105880

(56) Entgegenhaltungen:
- EP-A- 1 396 728
- WO-A-93/23915
- US-A- 5 973 941
- US-A1- 2003 076 086

## Beschreibung

Die Erfindung betrifft eine Einrichtung gemäß dem Oberbegriff des Anspruches 1.

In Niederspannungs-Schaltanlagen sind Messsensoren erforderlich, die die Spannung und den Strom innerhalb der Schaltanlage messen. Solche Sensoren sind in WO 93/23915 und US 2003/0076086 offenbart, sowie in US 5973941 und EP 1396728. Diese Messsensoren befinden sich auf Betriebspotential, so dass die in Schaltanlagen üblicherweise angewandten Messverfahren darauf beruhen, die Ausgangsgröße der Sensoren über magnetische Wandler in ein galvanisch freies Messsignal umzuwandeln, das dann zentral digitalisiert und weiter verarbeitet wird. Messverfahren, die die Messgröße direkt auf der Primärseite erfassen, z. B. Shunts, bzw. Messungen, die auf Shunts basieren, sind kaum im Einsatz.

Die zur Messung von Strom und Spannung in Drei-Phasen-Systemen überwiegend eingesetzten magnetischen Wandler weisen sekundärseitig prinzipbedingte Nichtlinearitäten und Phasenverschiebungen gegenüber dem Eingangssignal auf. Dies führt insbesondere bei der vektoriellen Auswertung von Strom und Spannung in den Drei-Phasen-Systemen zu Messfehlern.

Um eine präzise Messung von Strom, Spannung und Temperatur innerhalb beispielsweise von Startermodulen (zum Starten von Motoren) durchzuführen, sind Messmodule entwickelt worden, die direkt auf der Leistungsseite messen. Die Isolation zum Messkreis erfolgt erst nach der Digitalisierung der Messdaten.

Um die Leistung oder einen Erdschlussstrom in den Drei-Phasen-Systemen berechnen zu können, ist eine zeitsynchrone Abtastung der Messgrößen in allen drei Phasen erforderlich. Wird wie allgemein üblich auf jedem Messmodul ein Quarzoszillator zur Takterzeugung eingesetzt, so ergeben sich Unterschiede im Abtastzeitpunkt aufgrund der Toleranz der Quarze und deren unkorrelierter Phasenlage zueinander. Da beim Einsatz in Niederspannungsschaltanlagen eine Isolationsfestigkeit von einigen kV der Messkreise gegeneinander erforderlich ist, ergibt sich ein nicht unerheblicher schaltungstechnischer Aufwand, um ein zentral erzeugtes Referenztaktsignal auf drei Messmodule isoliert zu verteilen.

Aufgabe der Erfindung, ist es, eine Einrichtung der eingangs genannten Art zu schaffen, um über schon vorhandene Anordnungen eine Synchronisation der Messmodultakte zu erzielen.

Diese Aufgabe wird erfindungsgemäß gelöst durch die Merkmale des Anspruches 1.

Erfindungsgemäß ist dabei ein quarzgesteuerter Taktgenerator vorgesehen, dessen Ausgangssignale dem Netzteil zugeführt werden, so dass die Taktfrequenz der Netzteilausgangssignale für die Primärseiten der Transformatoren gleich sind, wobei die Frequenz innerhalb des Arbeitsbereiches der Transformatoren liegen.

Damit wird bei der erfindungsgemäßen Einrichtung das zur isolierten Stromversorgung von drei Messmodulen bereits vorhandene Schaltnetzteil verwendet, um über die gleiche Anordnung eine Synchronisation der Messmodultakte zu erzielen.

Gemäß einer vorteilhaften Ausgestaltung der Erfindung können die Sekundärseiten der Transformatoren mit je einer Schaltungsanordnung verbunden sein, mit der die Flankensignale der Taktfrequenz der Primärseiten zurück gewonnen werden. Damit wird erreicht, dass die Signale, die auf den Sekundärseiten der Transformatoren abgegeben werden, in die ursprüngliche, primärseitige Form gebracht werden.

Darüber hinaus ist eine weitere Schaltungsanordnung vorgesehen, der die Flankensignale zuführbar sind und die die Frequenz der Flankensignale vervielfacht den Messsensoren zuführt.

Weitere vorteilhafte Ausgestaltungen der Erfindung und weitere Verbesserungen sind den weiteren Unteransprüchen zu entnehmen.

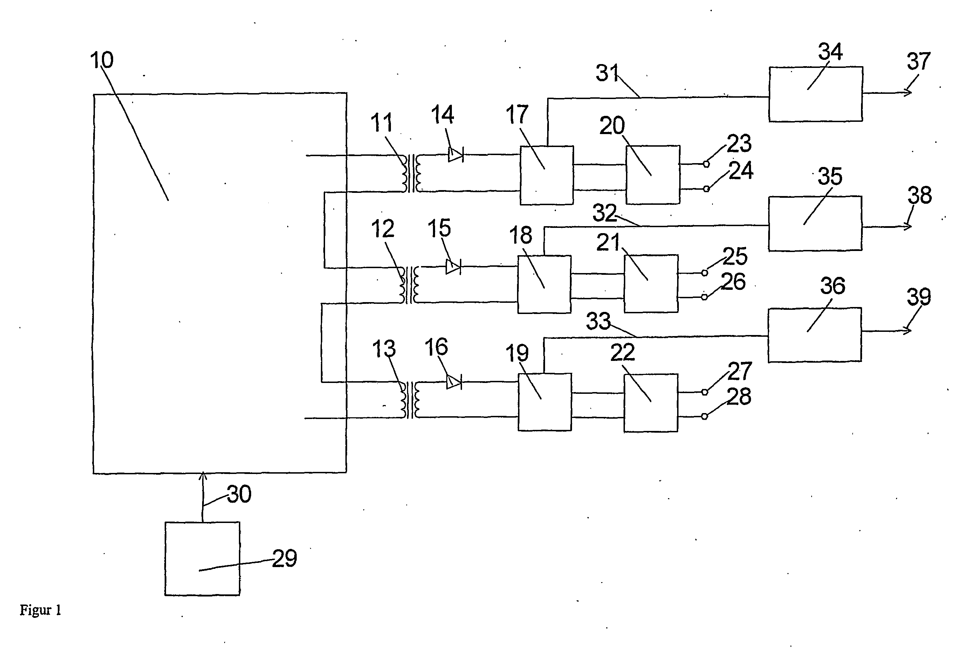

Anhand der Zeichnung, die schematisch ein Ausführungsbeispiel der Erfindung zeigt, sollen die Erfindung sowie weitere vorteilhafte Ausgestaltungen und Verbesserungen der Erfindung und weitere Vorteile näher erläutert und beschrieben werden.

Es zeigt
- einzige Fig.: eine schematische Zusammenschaltung der Einrichtung gemäß der Erfindung.

Die Einrichtung umfasst ein Netzteil 10, dessen Ausgangssignale einer der Anzahl der Phasen, wo gemessen wird, entsprechenden Anzahl von Transformatoren 11, 12 und 13 zugeführt werden. Das Netzteil oder auch Schaltnetzteil 10 ist in bekannter Technik, vorzugsweise in Flyback-Topologie, ausgelegt. Sekundärseitig wird die Ausgangsspannung der Transformatoren 11, 12 und 13 über Dioden 14, 15 und 16 gleichgerichtet und jeweils einer Schaltungsanordnung 20, 21, 22 zugeführt, die die gleichgerichtete Spannung stabilisiert und die als Ausgangsspannung zwischen den Klemmen 23, 24; 25, 26; 27, 28 ansteht; diese Ausgangsspannungen dienen zur Stromversorgung von nicht näher dargestellten Sensoren.

Dem Schaltnetzteil 10 ist eine Oszillatorschaltungsanordnung 29 zugeordnet, deren Ausgangssignale gemäß Pfeilrichtung 30 dem Netzteil 10 zugeführt werden, so dass die Ausgangssignale des Netzteiles, die der Primärseite der Transformatoren 11, 12 und 13 zugeführt werden, getaktet sind.

Zwischen der Sekundärseite der Transformatoren 11 bis 13 und den Schaltungsanordnungen 20 bis 22 befinden sich weitere Schaltungsanordnungen 17, 18, 19, in denen die Flankensignale der sekundärseitigen Ausgangssignale erfasst werden, so dass die Taktsignale an die der Oszillatorschaltungsanordnung 29 wieder angepasst werden. Damit wird sekundärseitig das Flankensignal des Primärtaktes zurück gewonnen.

Über Signalleitungen 31, 32 und 33 werden die in den Schaltungsanordnungen 17, 18 und 19 zurück gewonnenen Signalinformationen auf jedem Messmodul zur phasenstarren Synchronisation einer PLL-Schaltungsanordnung 34, 35 und 36 zugeführt, wodurch ein Ausgangssignal 37, 38 und 39 erzeugt wird, dessen Frequenz ein vielfaches der Eingangsfrequenz ist, und damit als Taktsignal von A/D-Wandlem der Messmodule dienen kann.

Die Taktsignale der drei Messmodule sind somit phasenstarr miteinander gekoppelt und ermöglichen so eine taktsynchrone Abtastung der Messgrößen in allen drei Messmodulen.

Die Abkürzung PLL bedeutet eine Phase-Lock-Loop-Schaltungsanordnung.

Die Transformatoren 11, 12 und 13 können auch durch eine Serienschaltung von zwei Teiltransformatoren ersetzt werden, wodurch die notwendige Isolationsfestigkeit erzielt wird. Es besteht natürlich auch die Möglichkeit, lediglich einen einzigen Transformator vorzusehen, der drei Sekundärwicklungen aufweist, deren Ausgangssignale jeweils über die Dioden 14, 15 und 16 gleich gerichtet und durch die anderen Schaltungsanordnungen weiter verarbeitet werden.

## Patentansprüche

1. Einrichtung zur Energieversorgung von Messsensoren und Übertragung eines synchronen Taktsignals an diese, insbesondere für eine Niederspannungsanlage, mit einem Netzteil, dessen Ausgangssignale über der Isolierung dienende Transformatoren an die Messsensoren übertragen werden, **dadurch gekennzeichnet, dass** eine quarzgesteuerte Oszillationsschaltungsanordnung (quarzgesteuerter Taktgenerator) vorgesehen ist, dessen Ausgangssignale dem Netzteil (10) zugeführt werden, so dass die Taktfrequenz der Netzteilausgangssignale für die Primärseiten der Transformatoren (11, 12, 13) gleich ist, wobei die Frequenz innerhalb des Arbeitsbereiches der Transformatoren (11, 12, 13) liegt.

2. Einrichtung nach Anspruch 1, **dadurch gekennzeichnet, dass** wenigstens zwei in Serie geschaltete Teiltransformatoren vorgesehen sind.

3. Einrichtung nach Anspruch 1, **dadurch gekennzeichnet, dass** ein Transformator vorgesehen ist, der drei Sekundärwicklungen aufweist.

4. Einrichtung nach einem der vorherigen Ansprüche, **dadurch gekennzeichnet, dass** die Sekundärseiten der Transformatoren mittels Gleichrichter (14, 15, 16) einer zweiten Schaltungsanordnung (20, 21, 22) zuführbar sind, in der die gleichgerichteten sekundärseitigen Signale stabilisierbar sind bzw. stabilisiert werden.

5. Einrichtung nach einem der vorherigen Ansprüche, **dadurch gekennzeichnet, dass** die Sekundärseiten des wenigstens einen Transformators mit je einer ersten Schaltungsanordnung verbunden sind, mit der die Flankensignale der Taktfrequenz der Primärseite zurück gewonnen werden.

6. Einrichtung nach einem der vorherigen Ansprüche, **dadurch gekennzeichnet**, dans eine weitere Schaltungsanordnung (34, 35, 36) vorgesehen ist, der die Flankensignale der ersten Schaltungsanordnungen (17, 18, 19) zuführbar sind und die die Frequenz dieser Signale vervielfacht den Messsensoren zuführt.

## Claims

1. Device for supplying power to measuring sensors and transmitting a synchronous clock signal thereto, in particular for a low-voltage assembly, having a switched mode power supply, whose output signals are transmitted to the measuring sensors via transformers used for isolation purposes, **characterized in that** a quartz-controlled oscillation circuit arrangement (quartz-controlled clock generator) is provided, whose output signals are fed to the switched mode power supply (10), with the result that the clock frequency of the switched mode power supply output signals is the same for the primary sides of the transformers (11, 12, 13), the frequency being within the working range of the transformers (11, 12, 13).

2. Device according to Claim 1, **characterized in that** at least two series-connected part-transformers are provided.

3. Device according to Claim 1, **characterized in that** a transformer is provided which has three secondary windings.

4. Device according to one of the preceding claims, **characterized in that** the secondary sides of the transformers can be fed by means of rectifiers (14, 15, 16) to a second circuit arrangement (20, 21, 22), in which the rectified secondary-side signals can be or are stabilized.

5. Device according to one of the preceding claims, **characterized in that** the secondary sides of the at least one transformer are connected to in each case one first circuit arrangement, with which the edge signals of the clock frequency of the primary side are recovered.

6. Device according to one of the preceding claims, **characterized in that** a further circuit arrangement (34, 35, 36) is provided to which the edge signals of the first circuit arrangements (17, 18, 19) can be fed and which feeds the frequency of these signals, multiplied, to the measuring sensors.

## Revendications

1. Equipement d'alimentation en énergie de capteurs de mesure et transmission d'un signal d'horloge synchrone à ces derniers, notamment pour une installation à basse tension, avec une partie réseau dont les signaux de sortie sont transmis aux capteurs de mesure à travers les transformateurs servant à l'isolation, **caractérisé en ce qu'**on dispose d'un agencement de circuit oscillateur piloté par quartz (générateur d'horloge piloté par quartz) dont les signaux de sortie alimentent la partie réseau (10) de telle sorte que la fréquence d'horloge des signaux de sortie de la partie réseau soit la même pour les côtés primaires des transformateurs (11, 12, 13), la fréquence se situant dans la plage de fonctionnement des transformateurs (11, 12, 13).

2. Equipement selon la revendication 1, **caractérisé en ce qu'**on dispose d'au moins deux transformateurs partiels branchés en série.

3. Equipement selon la revendication 1, **caractérisé en ce qu'**on dispose d'un transformateur comportant trois bobinages secondaires.

4. Equipement selon une des revendications précédentes, **caractérisé en ce que** les côtés secondaires des transformateurs peuvent alimenter, par l'intermédiaire de redresseurs (14, 15, 16), un deuxième agencement de circuits (20, 21, 22) dans lequel les signaux redressés du côté secondaire peuvent être stabilisés, respectivement sont stabilisés.

5. Equipement selon une des revendications précédentes, **caractérisé en ce que** les côtés secondaires d'au moins un transformateur sont reliés chacun à un premier agencement de circuits permettant de récupérer les signaux des flancs de la fréquence d'horloge du côté primaire.

6. Equipement selon une des revendications précédentes, **caractérisé en ce qu'**on dispose d'un autre agencement de circuits (34, 35, 36) qu'on peut alimenter avec les signaux des fronts des premiers agencements de circuits (17, 18, 19) et qui alimente les capteurs de mesure avec la fréquence multiple de ces signaux.
